# EUROPEAN PATENT APPLICATION

(11) **EP 4 641 216 A1**
(43) Date of publication of application: **29.10.2025**
(21) Application number: 25171732.8
(22) Date of filing: 22.04.2025
(51) Int. Cl.: G01P 15/125, B81B 3/00, G01P 15/08

(54) **MULTI-STAGE MEMS STOPPER DEVICE AND METHOD**

(30) Priority: 24.04.2024 US 202418645130
(71) Applicant: Analog Devices, Inc., Wilmington, MA 01887 (US)
(72) Inventor: ZHANG, Jianglong, Wilmington, 01887 (US); ZHANG, Xin, Wilmington, 01887 (US); DUNN, Tyler Adam, Wilmington, 01887 (US); VOHRA, Gaurav, Wilmington, 01887 (US); JUDY, Michael, Wilmington, 01887 (US); JIA, Kemiao, Wilmington, 01887 (US)
(74) Representative: Horler, Philip John

(57) **Abstract**

Devices and associated method are shown that include a mass movably coupled over a substrate. In selected configurations, a controlled contact system is coupled between the mass and the at least one stopper. Examples are also shown where the controlled contact system includes a first stage contact coupled to a flexible beam and a second stage contact.

## Description

This application claims priority from US patent application no. 18/645,130, filed on 24 April 2024.

### BACKGROUND

A variety of different applications use sensor systems to detect the movement of an underlying object. For example, inertial sensors, e.g., accelerometers or gyroscopes, are used in safety and navigation systems for automotive, military, aerospace and marine applications. Sensors may be formed using micromachining processes and may include microelectromechanical systems (MEMS). In MEMS devices, certain micromachined structures are designed to move relative to a substrate and other micromachined structures in response to forces applied in a predetermined manner, such as along a predetermined axis of the device. The movement of certain of the structures permits the generation of signals proportional to the magnitude, direction, and/or duration of the force.

For example, one type of MEMS accelerometer employs a movable mass constructed with fingers adjacent and parallel to fingers of one or more fixed, non-moving structures, with all of these structures suspended in a plane above the substrate. The movable structure and the fixed structure form a capacitor, having a capacitance that changes when the movable structure moves relative to the fixed structure in response to the force.

MEMS devices typically rely on fixed, rigid stoppers to prevent the movable mass from contacting other components or parts during a shock event. For example, if a finger from the movable structure moves into contact with a corresponding fixed finger, the fingers may stick due to electrostatic attraction, causing the device to fail. Moreover, excessive shock to the device may generate large impact forces that may break the MEMS structures or dislocate particles on the mass or fixed structures. These broken or dislocated components undesirably may fall into critical sensing areas and render the sensor inoperative. Furthermore, continuous shock may keep the mass contacting the stopper, thus wearing out the stoppers and causing stiction or electrostatic capture failures.

### BRIEF DESCRIPTION OF THE DRAWINGS

In the drawings, which are not necessarily drawn to scale, like numerals may describe similar components in different views. Like numerals having different letter suffixes may represent different instances of similar components. The drawings illustrate generally, by way of example, but not by way of limitation, various embodiments discussed in the present document.
FIG. 1A illustrates selected components of an electromechanical sensor in accordance with some example embodiments.
FIG. 1B illustrates selected components of another electromechanical sensor in accordance with some example embodiments.
FIG. 2 illustrates a top view of selected components of an electromechanical sensor in accordance with some example embodiments.
FIG. 3 illustrates selected components of a controlled contact system of an electromechanical sensor in accordance with some example embodiments.
FIG. 4 illustrates selected components of another controlled contact system of an electromechanical sensor in accordance with some example embodiments.
FIG. 5 illustrates selected components of another controlled contact system of an electromechanical sensor in accordance with some example embodiments.
FIG. 6 illustrates selected components of another controlled contact system of an electromechanical sensor in accordance with some example embodiments.
FIG. 7 illustrates selected components of another controlled contact system of an electromechanical sensor in accordance with some example embodiments.
FIG. 8 illustrates an example method flow diagram in accordance with other example embodiments.

### DETAILED DESCRIPTION

The following description and the drawings sufficiently illustrate specific embodiments to enable those skilled in the art to practice them. Other embodiments may incorporate structural, logical, electrical, process, and other changes. Portions and features of some embodiments may be included in, or substituted for, those of other embodiments. Embodiments set forth in the claims encompass all available equivalents of those claims.

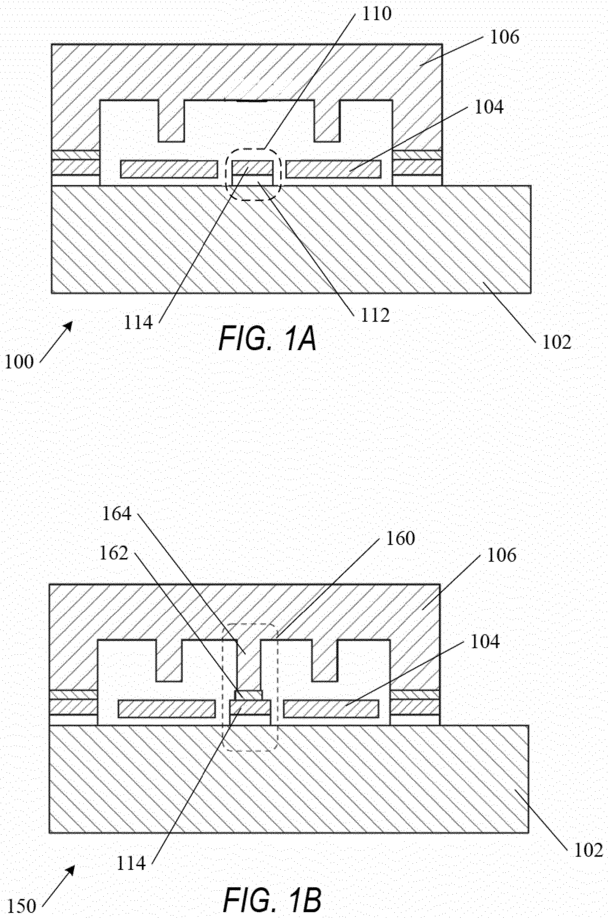

Figure 1A shows a side view of an electromechanical device 100. In one example, the electromechanical device 100 includes a microelectromechanical systems (MEMS) device. In one example, the electromechanical device 100 includes an accelerometer. In one example, the electromechanical device 100 includes a gyroscope. Other electromechanical devices that utilize stopper configurations as described are also within the scope of the present invention.

The example of Figure 1A includes a substrate 102, and a mass 104 movably coupled over the substrate 102. A cap 106 is further included over the mass 104. The cap 106 is coupled to the substrate 102, and provides mechanical integrity to and protection for components under the cap 106. A stopper 110 is highlighted by the dashed line in Figure 1A. In selected electromechanical devices, such as MEMS devices, stopper components are included. The stopper 110 is configured to prevent the mass 104 from contacting other components or parts during a shock event. In Figure 1A, a bottom spacer 112 is further shown setting a distance over the substrate 102 of the mass 104 and a fixed portion 114 of the stopper 110.

Figure 1B shows another example of an electromechanical device 150. A stopper 160 is highlighted by the dashed line in Figure 1B. The electromechanical device 150 is similar to the electromechanical device 100 of Figure 1A, however in Figure 1B, a cap post 164 is included. The cap post 164 is shown in Figure 1B coupled to the fixed portion 114 that may be cut from a single sheet of material also forming the mass 104, or may be formed by other materials. In Figure 1B, the cap post 164 is coupled to the fixed portion 114 with an attachment 162, although the invention is not so limited.

In selected examples, components are formed integrally to improve manufacturing efficiency and reduce cost. For example, stoppers and controlled contact systems described below can be made integrally. In other examples, cap posts and controlled contact systems described below can be made integrally.

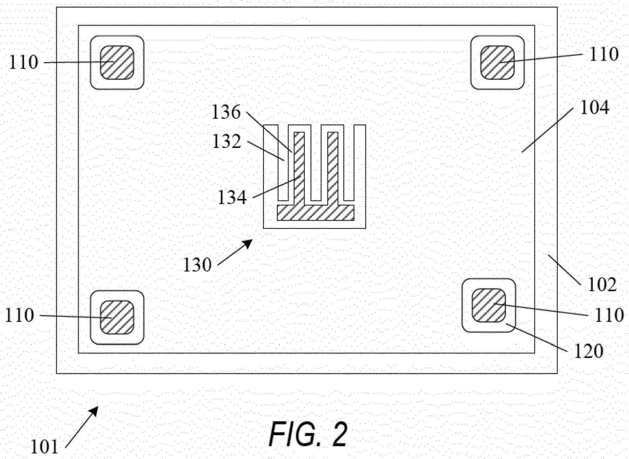

Figure 2 shows a block diagram view of an electromechanical device 101 similar to the electromechanical device from Figures 1A or 1B. A number of stoppers 110 are included to more effectively provide a stopping function across a large mass 104. Although the stoppers 110 are shown located within the mass 104, the invention is not so limited. One or more stoppers 110 may also be located outside, on a periphery of the mass 104. The mass 104 is shown suspended over the substrate 102 similar to the example in Figures 1A or 1B. A sensor 130 is shown in block diagram form within the mass 104. In one example, the sensor 130 includes a number of movable fingers 132 coupled to the movable mass 104. The sensor 130 further includes a number of fixed fingers 134 that are fixed in relation to the substrate 102. In operation, movement of the mass 104 causes the movable fingers 132 to move relative to the fixed fingers 134. The movable fingers 132 and the fixed fingers 134 are included as part of a detection circuit, and as a gap 136 between them changes, a capacitance in the detection circuit changes. In this way, motion is detected and characterized by the electromechanical device 100.

The stoppers 110 are also shown separated from the mass 104 by a stopper gap 120. As discussed above, the stoppers 110 and the fixed fingers 134 are fixed to the substrate 102 and the mass 104 is movable with respect to the substrate, the fixed fingers 134, and the stoppers 110. A number of different controlled contact systems are described in examples below that are coupled between the mass 104 and at least one stopper 110. As will be discussed in more detail below, various components are coupled to fixed components such as the stopper 110, and corresponding components or surfaces are coupled to the moving components such as the mass 104.

Although examples are discussed with a given component attached or located on a fixed stopper and a corresponding component or surface attached or located on the movable mass 104, the configurations can be reversed. For example, a flexible beam can be attached to a fixed stopper and a corresponding impact surface is on the movable mass. It is also within the scope of the invention for the flexible beam to be instead attached to the movable mass, and the corresponding impact surface to be on the fixed stopper. Similar to a pin and socket electrical connector, it is not important which side of the connection has which configuration. The interaction between the sides is what is important.

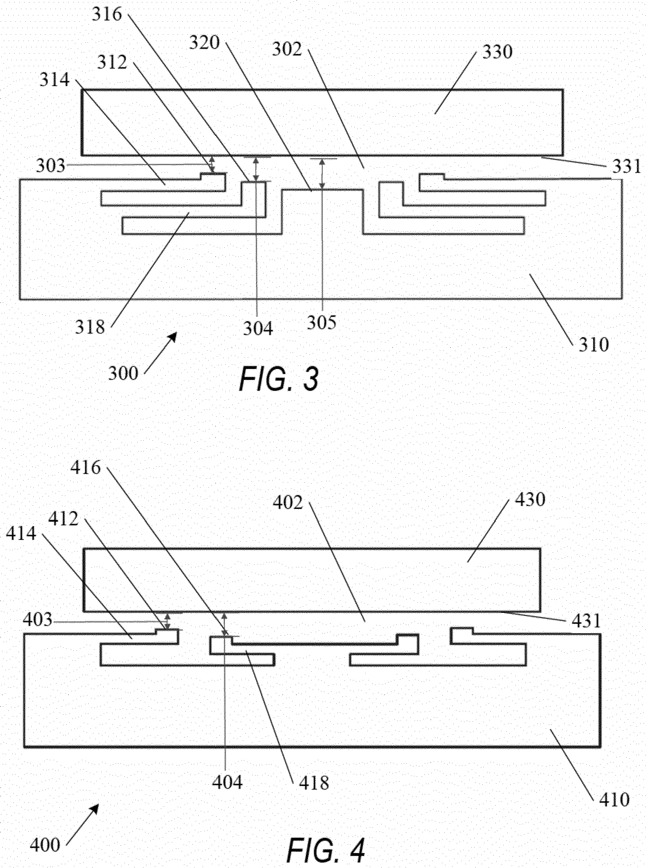

Figure 3 shows one example of a controlled contact system 300 that may be used in conjunction with a stopper 110 as shown in Figures 1 and 2. The controlled contact system 300 is located in one or more of the stopper gaps 120 as shown in Figures 1 and 2. The controlled contact system 300 includes a first body 310 and a second body 330 separated by a gap 302. As discussed above, the first body 310 can be coupled to either a fixed component such as a stopper 110, or a movable component such as mass 104. If the first body 310 is coupled to a fixed component, then the second body 330 is coupled to a corresponding movable component. Likewise, if the first body 310 is coupled to a movable component, then the second body 330 is coupled to a corresponding fixed component.

A first stage contact 312 is shown coupled to a first beam 314. The first stage contact 312 is configured to provide a first amount of flex upon impact when contact is made with opposing surface 331 of the second body 330. In the present disclosure, elements such as the first beam 314 are described as flexing. The first beam 314 is formed from a material such as a metal, semiconductor, or other material that behaves as a spring. When an impact occurs, such as the first stage contact 312 impacting an opposing surface 331 of the second body 330 the first beam 314 will flex as a result of a reaction force from the opposing surface 331. The flex in the first beam 314 provides an increasing force as the strain increases. Because of the first beam acting as a spring, the amount of flex softens an impact between the first body 310 and the second body 330.

Additionally, flex in the first beam 314 provides a more gradual interaction of force between the first stage contact 312 and the opposing surface 331, which provides decreased wear on any coatings that may be present on components of the system 300. In one example, self-assembled monolayer coatings are used to reduce stiction between components. In these examples, flexing of the beam 314 reduces an impact force and reduces wear on the coating. The flexing of the beam 314 also generates a restoring force that moves components of the system 300 back closer to their original locations, making the system 300 better situated for future impact events.

Flexing of the beam 314 also results in a rotation of the first stage contact 312 with respect to the opposing surface 331. Rotation of the first stage contact 312 results in a smaller surface area in actual contact with the opposing surface 331. The reduced contact area results in lower amounts of stiction. These advantages are described with respect to the first beam 314 and first stage contact 312, although the invention is not so limited. These advantages will also be present in other described flexing components.

The controlled contact system 300 of Figure 3 further shows a second stage contact 316. The second stage contact 316 is coupled to a second beam 318. Similar to the mechanism described above, when an impact occurs, such as the second stage contact 316 impacting the opposing surface 331 of the second body 330 the second beam 318 will flex as a result of a reaction force from the opposing surface 331. In one example, a stress-strain reaction in the second beam 318 is designed to be different than the first beam 314. In one example this is accomplished with different dimensions, such as thicknesses or width or length in the first beam 314 and the second beam 318. Also, as shown in Figure 3, the first stage contact 312 is spaced a first distance 303 from the opposing surface 331, while the second stage contact 316 is spaced a second distance 304 from the opposing surface 331, greater than the first distance 303. As shown, in an impact, the first stage contact 312 will contact the opposing surface 331 first, and after an amount of flex in the first beam 314, the second stage contact 316 will contact the opposing surface 331. If the impact progresses further, after an amount of flex in the first beam 314 and the second beam 318, a third stage contact surface 320 will contact the opposing surface 331. The third stage contact surface is shown spaced a third distance 305 from the opposing surface 331, greater than the second distance 304. In the example of Figure 3, the third stage contact surface is configured to provide substantially zero strain. In other words, if the third stage contact surface 320 is reached, there is a hard stop. In other examples, a third stage may include a third flexing configuration.

The configuration as shown provides a gradual, staged impact reaction that absorbs an impact force; mitigates shock to components; and reduces generation of particles from a rough impact. In the example of Figure 3, the first and second stages include a corresponding contact surface and beam in a symmetrical configuration. This configuration provides even reaction forces in direction normal to the opposing surface 331, however the invention is not so limited. Other configurations may include a single contact surface and beam or more than two contact surfaces and beams for each stage.

Figure 4 shows another example of a controlled contact system 400 that may be used in conjunction with a stopper 110 as shown in Figures 1 and 2. The controlled contact system 400 is located in one or more of the stopper gaps 120 as shown in Figures 1 and 2. The controlled contact system 400 includes a first body 410 and a second body 430 separated by a gap 402. Similar to the example of Figure 3, the first body 410 can be coupled to either a fixed component such as a stopper 110, or a movable component such as mass 104. If the first body 410 is coupled to a fixed component, then the second body 430 is coupled to a corresponding movable component. Likewise, if the first body 410 is coupled to a movable component, then the second body 430 is coupled to a corresponding fixed component.

A first stage contact 412 is shown coupled to a first beam 414. The first stage contact 412 is configured to contact an opposing surface 431 first in an impact. A second stage contact 416 is shown coupled to a second beam 418. The second stage contact 416 is configured to contact the opposing surface 431 subsequent to the first stage contact in the impact. As shown in Figure 4, the first stage contact 412 is spaced a first distance 403 from the opposing surface 431, while the second stage contact 416 is spaced a second distance 404 from the opposing surface 431, greater than the first distance 403.

Similar to the example of Figure 3, in the controlled contact system 400 of Figure 4, the first and second stages include a corresponding contact surface and beam in a symmetrical configuration. This configuration provides even reaction forces in direction normal to the opposing surface 431, however the invention is not so limited. Other configurations may include a single contact surface and beam or more than two contact surfaces and beams for each stage.

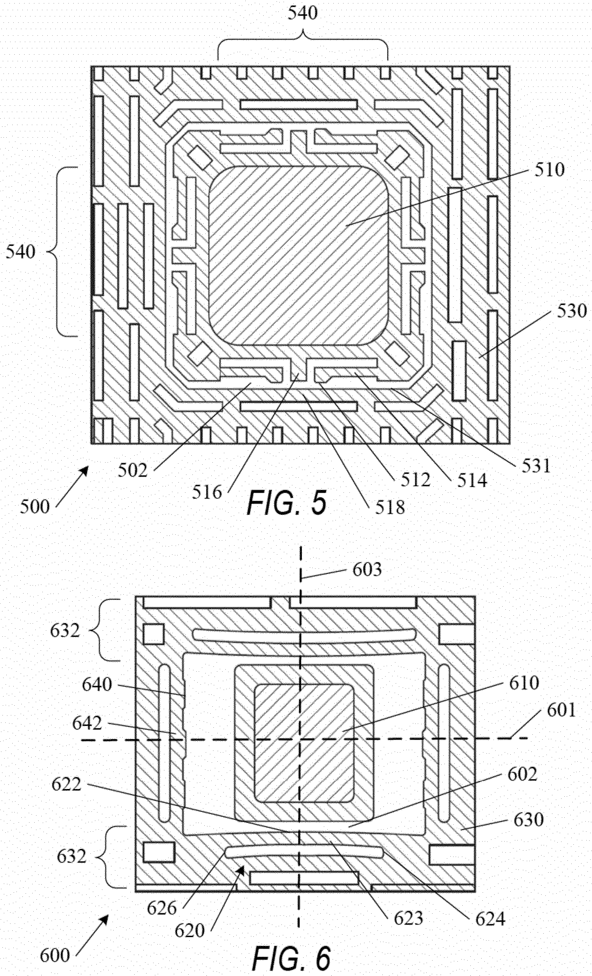

Figure 5 shows another example of an electromechanical device 500. A stopper 510 is shown, and a selected portion of a movable mass 530 is shown, separated by a gap 502. In the example of Figure 5, a controlled contact system is shown coupled to the stopper 510, although as discussed above, the invention is not so limited.

A first stage contact 512 is shown coupled to a first beam 514. The first stage contact 512 is configured to contact an opposing surface 531 first in an impact. A second stage contact 516 is also shown. The second stage contact 516 is configured to contact the opposing surface 531 subsequent to the first stage contact in the impact. In the example of Figure 5, the second stage contact 516 is substantially rigid, however an opposing surface 531 includes a beam 518 that includes an amount of flex to absorb an amount of impact force. The opposing surface beam 518 is shown constrained at two opposing ends, however the invention is not so limited. A cantilevered beam (constrained at only one end) is also within the scope of the invention. In other examples, the second stage contact 516 may be substantially rigid, and the opposing surface 531 may also be substantially rigid, resulting in a hard stop function from the second stage components. In one example, the second stage contact 516 may be coupled to a beam similar to the beam 518 on the opposing surface 531. As such, both sides of the impacting members may include a flexible beam.

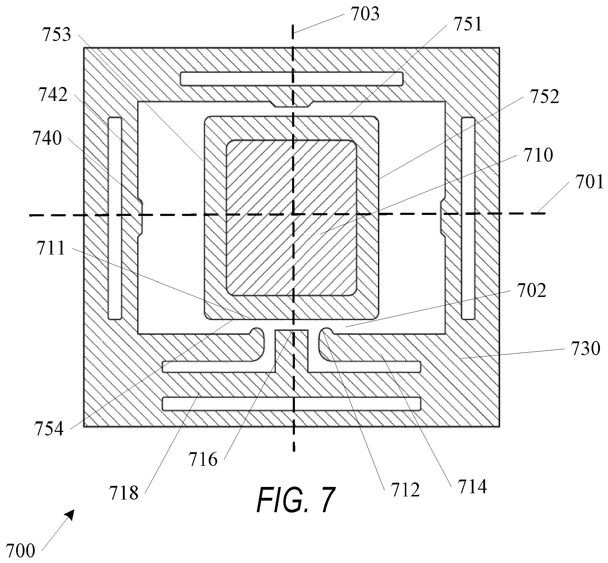

In the example of Figure 5, the first stage contact and the second stage contact are included in a pair 540. In the example of Figure 5, the controlled contact system includes four pairs 540, with each pair located on a side of a square stopper 510. This configuration provides an advantage of having similar staged, progressive reaction in the event of an impact in four different orthogonal directions. Other examples include different levels of staged, progressive reactions along selected different axes. This can be advantageous to refine selected axes of motion for additional protection where needed, and additional freedom of motion where needed. Examples of different reaction along different axes are described in more detail with respect to Figure 7.

Figure 6 shows another example of an electromechanical device 600. A stopper 610 is shown, and a selected portion of a movable mass 630 is shown, separated by a gap 602. In the example of Figure 6, a controlled contact system 620 is shown coupled to the movable mass 630, although as discussed above, the invention is not so limited.

In the example of Figure 6, the controlled contact system 620 includes a first contact 622 coupled to a beam 623. In the example of Figure 6, the beam 623 is configured to provide a non-linear reaction force response upon impact. In the example of Figure 6, the beam 623 is attached to the mass 630 on two opposing ends 624, 626 although the invention is not so limited. The beam 623 is shown with a curve, that provides a reaction force that changes as the beam 623 is compressed. Although a curved beam 623 is shown, other geometries of beam 623 are possible that provide a non-linear reaction force. For example, changes in thickness or cross section along the beam 623 will provide a non-linear reaction force. Other changes in geometry are also possible, to provide a non-linear reaction force, in contrast to a flat beam, that provides a linear reaction force response.

In the example of Figure 6, a pair 632 of first contacts 622 are included and each member of the pair is located on an opposing side of a square stopper 610. This configuration provides an advantage of having similar staged, progressive reaction in the event of an impact in two opposing directions along axis 603. The configuration of Figure 6 provides a larger range of motion along axis 601. Second contacts 640 are also included along axis 601, and the second contacts 640 are coupled to a second beam 642. In the example shown, multiple second contacts 640 are included on a single beam 642. By using multiple smaller contact surface second stage contacts 640, stiction is reduced between components after contact.

It should be noted that although first contacts 622 and second contacts 640 are shown in a single device 600, because the first contacts 622 act along axis 603 by themselves, they are defined as first stage contact. Because the second contacts 640 act along a different axis 601, they are also first stage contacts. In the present disclosure, second and third stage contacts, etc. act in conjunction with other contact components along single given axis such as axis 601, 603. Examples of second and third stage contacts are illustrated, at least in Figure 3, discussed above.

Figure 7 shows another example of an electromechanical device 700. A stopper 710 is shown, and a selected portion of a movable mass 730 is shown, separated by a gap 702. In the example of Figure 7, a controlled contact system is shown coupled to the movable mass 730, although as discussed above, the invention is not so limited.

A first stage contact 712 is shown coupled to a first beam 714. The first stage contact 712 is configured to contact an opposing surface 711 first in an impact. A second stage contact 716 is also shown. The second stage contact 716 is configured to contact the opposing surface 711 subsequent to the first stage contact in the impact. In the example of Figure 7, the second stage contact 716 is coupled to a second beam 718 that provides an amount of flex to absorb an amount of impact force.

Other configurations are also within the scope of the invention where contacts 712, 716 are altered such that 716 becomes a first stage contact and 712 becomes a second stage contact. Variations in the shapes of components determine which contact surface contacts an opposing surface first in an impact. In one example, the first structure to make contact is defined as the first stage contact.

The configuration of Figure 7 provides a larger range of motion along axis 701 than along axis 703. Third contacts 740 are included along axis 701, and the third contacts 740 are coupled to a third beam 742. By using multiple smaller contact surface third contacts 740, stiction is reduced between components after contact. The example of Figure 7 shows another illustration of anisotropic arrangement of stopping function along different axes. Single stage controlled contact systems are shown on sides 751, 752, and 753 of the stopper 710. A two-stage controlled contact system is shown on side 754 of the stopper 710. As noted above, configurations such as Figure 7, or variations on this arrangement can be advantageous to refine selected axes of motion for additional protection where needed, and additional freedom of motion where needed. Although in the example of Figure 7, a two-stage controlled contact system is only shown on one side, the invention is not so limited. Different stage systems can be mixed and combined on any combination of sides of controlled contact systems. Additionally, several stopper systems such as those shown in Figure 7 can be placed symmetrically at different locations in a sensor.

In addition to the controlled contact system being mounted to either fixed or movable components as described above, individual stage components of controlled contact systems can be mounted to different sides in a fixed and movable component arrangement. For example, a first stage contact can be mounted to a fixed side, and a second stage contact can be mounted to a movable side, or vice versa. Also, the controlled contact system component stages can be divided between several stoppers in a multiple stopper arrangement. For example, a first stage contact can be mounted in a gap adjacent to a first stopper, and a second stage contact can be mounted in a gap adjacent to a second stopper. Because the mass is movable relative to all of several stoppers, as illustrated in Figure 2, the components can be spread out among several different stoppers, and still provide a staged, progressive reaction in the event of an impact. Further, different stoppers can be configured to only provide a stopping function along selected axes. A combination of several stoppers with individual axes of operation can then be configured to address multiple axes of stopping function. Although examples shown include first and second stage contacts, one of ordinary skill in the art, having the benefit of the present disclosure, will recognize that for any given axis of motion and direction of motion, single, two stage, or more than two stage controlled contact systems can be used.

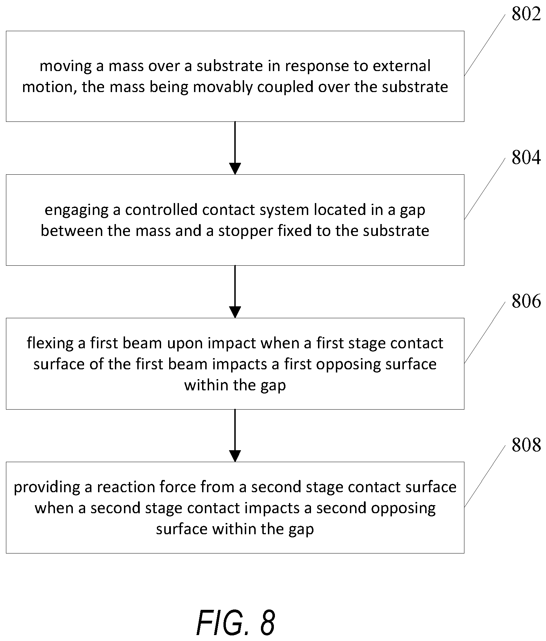

Figure 8 shows a flow diagram of one example method of operating an electromechanical device. In operation 802, a mass is moved over a substrate in response to external motion. In operation 804, a controlled contact system is located in a gap between the mass and a stopper fixed to the substrate. The controlled contact system is engaged in operation 804. In operation 806, a first beam is flexed upon impact when a first stage contact surface of the first beam impacts a first opposing surface within the gap. In operation 808, a reaction force is provided from a second stage contact surface when a second stage contact impacts a second opposing surface within the gap.

The above detailed description includes references to the accompanying drawings, which form a part of the detailed description. The drawings show, by way of illustration, specific embodiments in which the invention can be practiced. These embodiments are also referred to herein as "examples". Such examples can include elements in addition to those shown or described. However, the present inventor also contemplates examples in which only those elements shown or described are provided. Moreover, the present inventor also contemplates examples using any combination or permutation of those elements shown or described (or one or more aspects thereof), either with respect to a particular example (or one or more aspects thereof), or with respect to other examples (or one or more aspects thereof) shown or described herein.

All publications, patents, and patent documents referred to in this document are incorporated by reference herein in their entirety, as though individually incorporated by reference. In the event of inconsistent usages between this document and those documents so incorporated by reference, the usage in the incorporated reference(s) should be considered supplementary to that of this document; for irreconcilable inconsistencies, the usage in this document controls.

In this document, the terms "a" or "an" are used, as is common in patent documents, to include one or more than one, independent of any other instances or usages of "at least one" or "one or more." In this document, the term "or" is used to refer to a nonexclusive or, such that "A or B" includes "A but not B," "B but not A," and "A and B," unless otherwise indicated. In the appended claims, the terms "including" and "in which" are used as the plain-English equivalents of the respective terms "comprising" and "wherein". Also, in the following claims, the terms "including" and "comprising" are open-ended, that is, a system, device, article, or process that includes elements in addition to those listed after such a term in a claim are still deemed to fall within the scope of that claim. Moreover, in the following claims, the terms "first," "second," and "third," etc. are used merely as labels, and are not intended to impose numerical requirements on their objects.

In various examples, the components, controllers, processors, units, engines, or tables described herein can include, among other things, physical circuitry or firmware stored on a physical device. As used herein, "processor" means any type of computational circuit such as, but not limited to, a microprocessor, a microcontroller, a graphics processor, a digital signal processor (DSP), or any other type of processor or processing circuit, including a group of processors or multi-core devices.

The term "horizontal" as used in this document is defined as a plane parallel to the conventional plane or surface of a substrate, such as that underlying a wafer or die, regardless of the actual orientation of the substrate at any point in time. The term "vertical" refers to a direction perpendicular to the horizontal as defined above. Prepositions, such as "on," "over," and "under" are defined with respect to the conventional plane or surface being on the top or exposed surface of the substrate, regardless of the orientation of the substrate; and while "on" is intended to suggest a direct contact of one structure relative to another structure which it lies "on"(in the absence of an express indication to the contrary); the terms "over" and "under" are expressly intended to identify a relative placement of structures (or layers, features, etc.), which expressly includes--but is not limited to--direct contact between the identified structures unless specifically identified as such. Similarly, the terms "over" and "under" are not limited to horizontal orientations, as a structure may be "over" a referenced structure if it is, at some point in time, an outermost portion of the construction under discussion, even if such structure extends vertically relative to the referenced structure, rather than in a horizontal orientation.

It will be understood that when an element is referred to as being "on," "connected to" or "coupled with" another element, it can be directly on, connected, or coupled with the other element or intervening elements may be present. In contrast, when an element is referred to as being "directly on," "directly connected to" or "directly coupled with" another element, there are no intervening elements or layers present. If two elements are shown in the drawings with a line connecting them, the two elements can be either be coupled, or directly coupled, unless otherwise indicated.

Method examples described herein can be machine or computer-implemented at least in part. Some examples can include a computer-readable medium or machine-readable medium encoded with instructions operable to configure an electronic device to perform methods as described in the above examples. An implementation of such methods can include code, such as microcode, assembly language code, a higher-level language code, or the like. Such code can include computer-readable instructions for performing various methods. The code may form portions of computer program products. Further, the code can be tangibly stored on one or more volatile or non-volatile tangible computer-readable media, such as during execution or at other times. Examples of these tangible computer-readable media can include, but are not limited to, hard disks, removable magnetic disks, removable optical disks (e.g., compact disks and digital video disks), magnetic cassettes, memory cards or sticks, random access memories (RAMs), read only memories (ROMs), and the like.

To better illustrate the method and apparatuses disclosed herein, a non-limiting list of embodiments is provided here:
Example 1. An electromechanical device, comprising: a mass movably coupled over a substrate; at least one stopper fixed to the substrate; a controlled contact system coupled between the mass and the at least one stopper, the controlled contact system including; a first stage contact coupled to a flexible beam, the first stage contact configured to contact an opposing surface first in an impact; and a second stage contact configured to contact the opposing surface subsequent to the first stage contact in the impact.

Example 2. The electromechanical device of example 1, wherein the second stage contact is coupled to a second flexible beam.

Example 3. The electromechanical device of example 1, wherein the flexible beam is cantilevered from one end.

Example 4. The electromechanical device of example 1, wherein the first stage contact is located adjacent to the second stage contact.

Example 5. The electromechanical device of example 4, wherein the first stage contact and the second stage contact are included in a pair, and wherein the controlled contact system includes four pairs, with each pair located on a side of a square stopper.

Example 6. The electromechanical device of example 1, wherein the at least one stopper includes a first stopper fixed to the substrate and a second stopper fixed to the substrate; wherein the first stage contact is coupled between the mass and the first stopper; and wherein the second stage contact is coupled between the mass and the second stopper.

Example 7. The electromechanical device of example 1, wherein the controlled contact system is coupled to the stopper.

Example 8. The electromechanical device of example 1, wherein first stage contact is coupled to the mass, and the second stage contact is coupled to the stopper.

Example 9. The electromechanical device of example 1, further including a third stage contact configured to contact the opposing surface subsequent to the second stage contact in the impact.

Example 10. An electromechanical device, comprising: a mass movably coupled over a substrate; a stopper fixed to the substrate; a controlled contact system coupled between mass and the stopper, the controlled contact system including; a first stage contact coupled to a beam configured to provide a non-linear reaction force response upon impact.

Example 11. The electromechanical device of example 10, wherein the beam is curved.

Example 12. The electromechanical device of example 10, wherein the beam is attached to a base on two opposing ends.

Example 13. The electromechanical device of example 12, wherein a pair of first stage contact are included and each member of the pair is located on an opposing side of a square stopper.

Example 14. The electromechanical device of example 10, further including a second stage contact configured to contact an opposing surface subsequent to the first stage contact in the impact.

Example 15. The electromechanical device of example 10, wherein the controlled contact system is coupled to the stopper.

Example 16. The electromechanical device of example 10, wherein the controlled contact system is coupled to the mass.

Example 17. A method of operating an electromechanical device, comprising: moving a mass over a substrate in response to external motion, the mass being movably coupled over the substrate; engaging a controlled contact system located in a gap between the mass and a stopper fixed to the substrate, including; flexing a first beam upon impact when a first stage contact of the first beam impacts a first opposing surface within the gap; and providing a reaction force from a second stage contact when a second stage contact impacts a second opposing surface within the gap.

Example 18. The method of example 17, wherein providing a reaction force includes flexing a second beam upon impact when the second stage contact impacts the second opposing surface within the gap.

Example 19. The method of example 17, wherein flexing a first beam includes flexing a curved first beam.

Example 20. The method of example 17, further including rotating the first stage contact while flexing the first beam.

The above description is intended to be illustrative, and not restrictive. For example, the above-described examples (or one or more aspects thereof) may be used in combination with each other. Other embodiments can be used, such as by one of ordinary skill in the art upon reviewing the above description. The Abstract is provided to comply with 37 C.F.R. §1.72(b), to allow the reader to quickly ascertain the nature of the technical disclosure. It is submitted with the understanding that it will not be used to interpret or limit the scope or meaning of the claims. Also, in the above Detailed Description, various features may be grouped together to streamline the disclosure. This should not be interpreted as intending that an unclaimed disclosed feature is essential to any claim. Rather, inventive subject matter may lie in less than all features of a particular disclosed embodiment. Thus, the following claims are hereby incorporated into the Detailed Description, with each claim standing on its own as a separate embodiment, and it is contemplated that such embodiments can be combined with each other in various combinations or permutations. The scope of the invention should be determined with reference to the appended claims, along with the full scope of equivalents to which such claims are entitled.

## Claims

1. An electromechanical device, comprising:
a mass movably coupled over a substrate;
at least one stopper fixed to the substrate;
a controlled contact system coupled between the mass and the at least one stopper, the controlled contact system including;
a first stage contact coupled to a flexible beam, the first stage contact configured to contact an opposing surface first in an impact; and
a second stage contact configured to contact the opposing surface subsequent to the first stage contact in the impact.

2. The electromechanical device of claim 1, wherein the second stage contact is coupled to a second flexible beam.

3. The electromechanical device of any preceding claim, wherein the flexible beam is cantilevered from one end.

4. The electromechanical device of any preceding claim, wherein the first stage contact is located adjacent to the second stage contact.

5. The electromechanical device of claim 4, wherein the first stage contact and the second stage contact are included in a pair, and wherein the controlled contact system includes four pairs, with each pair located on a side of a square stopper.

6. The electromechanical device of any preceding claim, wherein the at least one stopper includes a first stopper fixed to the substrate and a second stopper fixed to the substrate;
wherein the first stage contact is coupled between the mass and the first stopper; and
wherein the second stage contact is coupled between the mass and the second stopper.

7. The electromechanical device of any preceding claim, wherein the controlled contact system is coupled to the stopper.

8. The electromechanical device of any preceding claim, wherein first stage contact is coupled to the mass, and the second stage contact is coupled to the stopper.

9. The electromechanical device of any preceding claim, further including a third stage contact configured to contact the opposing surface subsequent to the second stage contact in the impact.

10. An electromechanical device, comprising:
a mass movably coupled over a substrate;
a stopper fixed to the substrate;
a controlled contact system coupled between mass and the stopper, the controlled contact system including;
a first stage contact coupled to a beam configured to provide a non-linear reaction force response upon impact.

11. The electromechanical device of claim 10, wherein at least one of the following applies:
(a) the beam is curved;
(b) the electromechanical device further includes a second stage contact configured to contact an opposing surface subsequent to the first stage contact in the impact;
(c) the controlled contact system is coupled to the stopper;
(d) the controlled contact system is coupled to the mass

12. The electromechanical device of claim 10 or claim 11, wherein the beam is attached to a base on two opposing ends,
and optionally wherein a pair of first stage contact are included and each member of the pair is located on an opposing side of a square stopper.

13. A method of operating an electromechanical device, comprising:
moving a mass over a substrate in response to external motion, the mass being movably coupled over the substrate;
engaging a controlled contact system located in a gap between the mass and a stopper fixed to the substrate, including;
flexing a first beam upon impact when a first stage contact of the first beam impacts a first opposing surface within the gap; and
providing a reaction force from a second stage contact when a second stage contact impacts a second opposing surface within the gap.

14. The method of claim 13, wherein providing a reaction force includes flexing a second beam upon impact when the second stage contact impacts the second opposing surface within the gap.

15. The method of claim 13 or claim 14, wherein at least one of the following applies:
(a) flexing a first beam includes flexing a curved first beam;
(b) the method further includes rotating the first stage contact while flexing the first beam.
